# EUROPEAN PATENT APPLICATION

(11) **EP 4 694 590 A1**
(43) Date of publication of application: **11.02.2026**
(21) Application number: 24784880.7
(22) Date of filing: 01.04.2024
(51) Int. Cl.: H05K 3/46

(54) **METHOD FOR MANUFACTURING SUBSTRATE WITH BUILT-IN COMPONENT AND SUBSTRATE WITH BUILT-IN COMPONENT**

(30) Priority: 04.04.2023 JP 2023060745
(71) Applicant: FUJIKURA LTD., Tokyo 135-8512 (JP)
(72) Inventor: SATO, Shunsuke, Sakura-shi, Chiba 285-8550 (JP); UETA, Nobuki, Tokyo 135-8512 (JP)
(74) Representative: Ter Meer Steinmeister & Partner
(86) International application number: PCT/JP2024/013470
(87) International publication number: WO 2024/210095

(57) **Abstract**

A method of manufacturing a device-embedded board includes: steps S10 to S30 of preparing an electronic device 10, an inner board 40 and outer boards 50B and 60B; a step S40 of temporarily fixing the electronic device 10 to the outer board 50B; a step S50 of stacking the outer boards 50B and 60B and the inner board 40 with each other so that the electronic device 10 is inserted into the first opening 411; and a step S60 of fixing the outer boards 50B and 60B and the inner board 40 to each other. The electronic device 10 includes: a device main body 20; an insulating layer 33 having an opening 331; and a wiring layer 34 disposed on the insulating layer 33 to cover the opening 331. The second step S40 includes pressing the electronic device 10 against the outer board 50B in a state in which the conductive paste 55B is in contact with the wiring layer 34.

## Description

### [TECHNICAL FIELD]

The present invention relates to a method of manufacturing device-embedded board and a device-embedded board.

For designated countries that are permitted to be incorporated by reference in the literature, the contents of Japanese Patent Application No. 2023-60745 filed with Japan Patent Office on April 4, 2023 is incorporated herein by reference and is regarded as a part of the description of this specification.

### [BACKGROUND ART]

A multilayer wiring board is known in which a pad of a conductive layer formed in an electronic device such as an IC chip and a pad of a substrate with a wiring are connected by a through electrode made of a conductive paste (refer to, for example, Patent Document 1 (paragraphs [0074] to [0075] and FIG. 10)). In this multilayer wiring board, while exposing a land portion of the conductor layer from an opening of an insulating layer in the electronic device, a portion of the conductor layer other than the land portion is covered with the insulating layer, and the surface of the land portion is lower than the surface of the insulating layer (refer to, for example, Patent Document 1 (paragraphs [0087] to [0088] and FIG. 12(a) to FIG. 12(c)).

In the manufacturing process of this multilayer wiring board, the adhesive and conductive paste are heated below their curing temperatures to temporarily fix the electronic device to the substrate with the wiring. Then, another substrate with a wiring, a spacer, and a support board are stacked on this substrate with the wiring, and then the laminated body is collectively heated and pressed. The adhesive and the conductive paste are cured by this thermal compression bonding (refer to, for example, Patent Document 1 (paragraphs [0077] to [0082], FIG. 5(f) and FIG. 11(a) to FIG. 11(b))).

### [CITATION LIST]

### [PATENT DOCUMENT]

PATENT DOCUMENT 1: WO 2007/043639 A1

### [SUMMARY OF THE INVENTION]

### [PROBLEMS TO SOLVED BY INVENTION]

In the above-described multilayer wiring board, since the tackiness of the adhesive and the conductive paste is used for temporarily fixing the electronic device to the substrate and the conductive paste is not pressed against the conductor layer of the electronic device, the manufacturing process may proceed to the thermal compression bonding process in a state in which the conductive particles contained in the conductive paste are not in sufficient contact with the conductor layer, and the conductive paste may be cured. In addition, since the surface of the land portion of the conductor layer is lower than the surface of the insulating layer, the adhesive may come into contact with the insulating layer before the conductive paste comes into contact with the land portion, and the adhesive may flow into the interface of the conductive paste and the land portion during the thermal compression bonding process. Therefore, the above-described multilayer wiring board has a reliability problem with the electrical connection between the conductor layer of the electronic device and the through electrode.

An object of the present invention is to provide a method of manufacturing a device-embedded board and a device-embedded board capable of improving reliability of electrical connection between an electronic device and a board, and a device embedded board.

### [MEANS FOR SOLVING PROBLEM]

[1] An aspect 1 of the present invention is a method of manufacturing a device-embedded board comprising: a first step of preparing an electronic device, an inner board having a first opening capable of accommodating the electronic device, a first outer board having a through hole filled with conductive paste, and a second outer board; a second step of temporarily fixing the electronic device to the first outer board; a third step of stacking the first and second outer boards and the inner board with each other so that the electronic device is inserted into the first opening and the inner board is sandwiched between the first and second outer boards; and a fourth step of fixing the first and second outer boards and the inner board to each other by heating and pressing the first and second outer boards and the inner board; wherein the electronic device comprises: a device main body having a first main surface in which an electrode pad is disposed; a first insulating layer having a second opening and disposed on the first main surface side with respect to the device main body; and a first wiring layer disposed on the first insulating layer to cover the second opening and electrically connected to the electrode pad, the second step includes pressing the electronic device against the first outer board in a state in which the conductive paste is in contact with the first wiring layer.
[2] An aspect 2 of the present invention may be the method of manufacturing the device-embedded board of the aspect 1, wherein the first wiring layer may comprise: a concave part disposed in the second opening; and a convex part disposed on the first insulating layer, and the second step may include pressing the electronic device against the first outer board in a state in which the conductive paste overlaps the convex part and the concave part when viewed along a pressing direction.
[3] An aspect 3 of the present invention may be the method of manufacturing the device-embedded board of the aspect 1 or 2, wherein the first wiring layer may comprise: a concave part disposed in the second opening; and a convex part disposed on the first insulating layer, the concave part may have an inner diameter smaller than an outer diameter of the conductive paste, and the second step may include bringing the conductive paste into contact with a portion of the convex part adjacent to an outer edge of the concave part over an entire circumference.
[4] An aspect 4 of the present invention may be the method of manufacturing the device-embedded board of the aspect 2 or 3, wherein the electronic device may comprise: a second insulating layer having a third opening and interposed between the device main body and the first insulating layer; and a second wiring layer disposed on the second insulating layer to cover the third opening and electrically connected to the electrode pad, the first insulating layer may be laid on the second insulating layer so that the first insulating layer covers the second wiring layer and a part of the second wiring layer faces the second opening, and the first wiring layer may be connected to the second wiring layer via the second opening.
[5] An aspect 5 of the present invention may be the method of manufacturing the device-embedded board of the aspect 4, wherein the second insulating layer may be laid on the device main body so that the third opening faces the electrode pad.
[6] An aspect 6 of the present invention may be the method of manufacturing the device-embedded board of any one of the aspects1 to 5, wherein the first outer board may comprise: a substrate having an electrical insulation; a third wiring layer disposed on a second main surface of the substrate; and an adhesive disposed on a third main surface of the substrate, the through hole may penetrate the substrate and the adhesive and may be closed by the third wiring layer, the conductive paste may be in contact with the third wiring layer, and the second step may include pressing the electronic device against the first outer board while heating the adhesive in a state in which the conductive paste is in contact with the first wiring layer.
[7] An aspect 7 of the present invention is a device-embedded board comprising: an electronic device; a first outer board on which the electronic device is mounted, an inner board having a first opening accommodating the electronic device and laid on the first outer board; and a second outer board laid on the inner board to cover the electronic device, the electronic device comprises: a device main body having a first main surface in which an electrode pad is disposed; a first insulating layer having a second opening and disposed on the first main surface side with respect to the device main body; and a first wiring layer disposed on the first insulating layer to cover the second opening and electrically connected to the electrode pad, the first wiring layer comprises: a concave part disposed in the second opening; and a convex part disposed on the first insulating layer, the first outer board comprises a conductive paste via connected to the first wiring layer, and the conductive paste via is connected to the convex part and the concave part.
[8] An aspect 8 of the present invention may be the device-embedded board of the aspect 7, wherein the concave part may have an inner diameter smaller than an outer diameter of the conductive paste via, and the conductive paste via may be connected to a portion of the convex part adjacent to an outer edge of the concave part over an entire circumference.
[9] An aspect 9 of the present invention may be the device-embedded board of the aspect 7 or 8, wherein the electronic device may comprise: a second insulating layer having a third opening and interposed between the device main body and the first insulating layer; and a second wiring layer disposed on the second insulating layer to cover the third opening and electrically connected to the electrode pad, the first insulating layer may be laid on the second insulating layer so that the first insulating layer covers the second wiring layer and a part of the second wiring layer faces the second opening, and the first wiring layer may be connected to the second wiring layer via the second opening.
[10] An aspect 10 of the present invention may be the device-embedded board of the aspect 9, wherein the second insulating layer may be laid on the device main body so that the third opening faces the electrode pad.
[11] An aspect 11 of the present invention may be the device-embedded board of any one of the aspects 7 to 10, wherein the first outer board may comprise: an insulating substrate having an electrical insulation; a third wiring layer disposed on a second main surface of the insulating substrate; and an adhesive disposed on a third main surface of the insulating substrate, the device-embedded board may have a through hole that penetrates the insulating substrate and the adhesive and that is closed by the third wiring layer, and the conductive paste via may be disposed in the through hole and may be connected to the third wiring layer.

### [EFFECT OF THE INVENTION]

In the present invention, since the electronic device and the first outer board are pressed in a state in which the conductive paste is in contact with the first wiring layer of the electronic device when the electronic device and the first outer board are temporarily fixed to each other, the manufacturing process can proceed to the fourth step in a state in which the conductive particles contained in the conductive paste are in sufficient contact with the conductor layer of the electronic device, and the conductive paste can be cured. In the present invention, since the first wiring layer of the electronic device comprises, in addition to the concave part disposed in the second opening, a convex part disposed on the first insulating layer and the conductive paste via is connected to the convex part and the concave part, the conductive paste can be first brought into contact with the convex part when the electronic device is temporarily fixed to the first outer board. Therefore, in the present invention, it is possible to improve the reliability of the electrical connection between the electronic device and the first outer board.

### [BRIEF DESCRIPTION OF DRAWING(S)]

FIG. 1 is a cross-sectional view showing the device-embedded board in the embodiment of the present invention;
FIG. 2 is a cross-sectional view showing the re-wiring structure of the electronic device in the embodiment of the present invention and is an enlarged view of portion II in FIG. 1;
FIG. 3 is a diagram showing the positional relationship between the conductive paste via and the concave part of the conductive layer in the embodiment of the present invention and is a cross-sectional view taken along line III-III in FIG. 2;
FIG. 4 is a flowchart showing the method of manufacturing the device-embedded board in the embodiment of the present invention;
FIG. 5(a) to FIG. 5(e) are cross-sectional views showing the method of forming the re-wiring structure of the electronic device in the embodiment of the present invention and are diagrams showing details of step S10 in FIG. 4;
FIG. 6 (a) to FIG. 6 (e) are cross-sectional views showing the method of forming the inner board in the embodiment of the present invention and are diagrams showing details of step S20 in FIG. 4;
FIG. 7 (a) to FIG. 7 (e) are cross-sectional views showing the method of forming the outer board in the embodiment of the present invention and are diagrams showing details of step S30 in FIG. 4;
FIG. 8(a) and FIG. 8(b) are cross-sectional views showing the method of forming the device-embedded board in the embodiment of the present invention, FIG. 8(a) is a diagram showing step S40 in FIG. 4, and FIG. 8(b) is a diagram showing step S50 in FIG. 4; and
FIG. 9(a) to FIG. 9(d) are diagrams showing details of steps S40 and S60 in FIG. 4 and are enlarged views corresponding to portion IX in FIG. 8(a).

### [MODE(S) FOR CARRYING OUT THE INVENTION]

Hereinafter, an embodiment of the invention will be described with reference to the drawings.

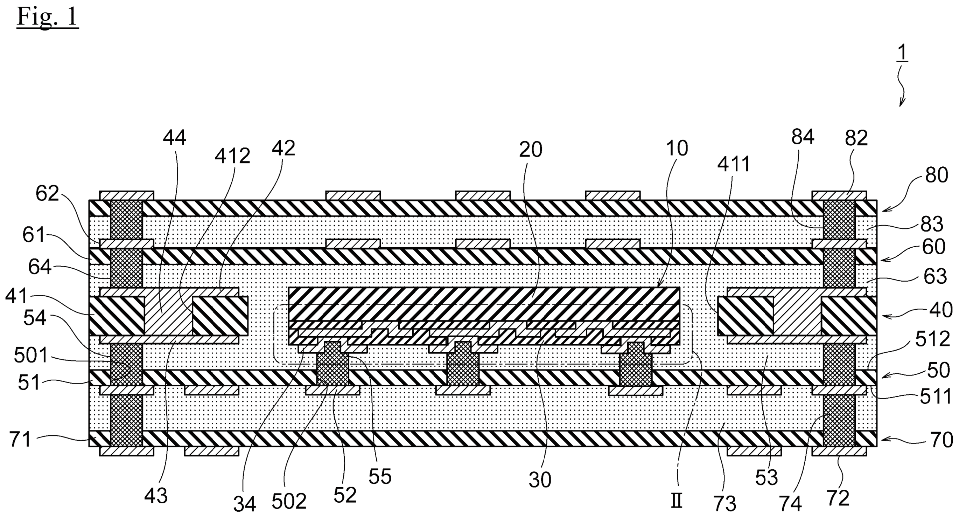

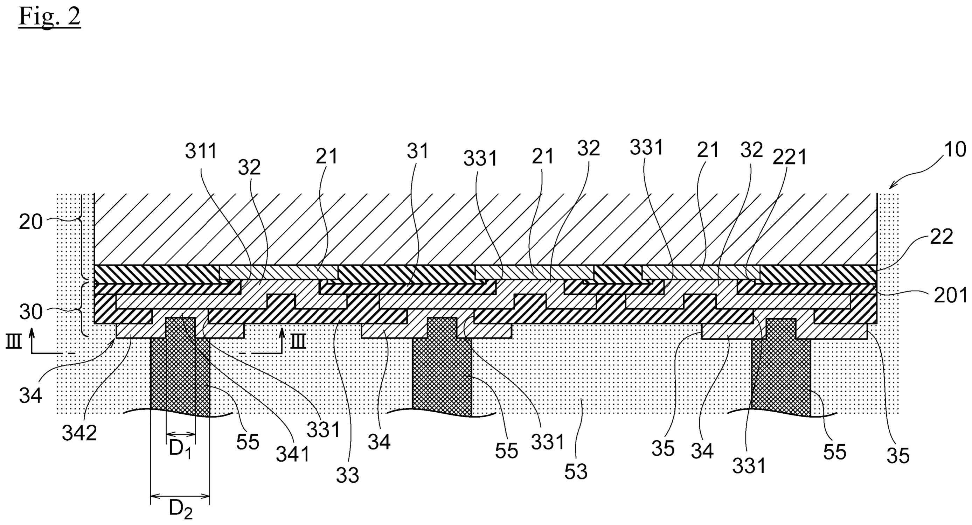

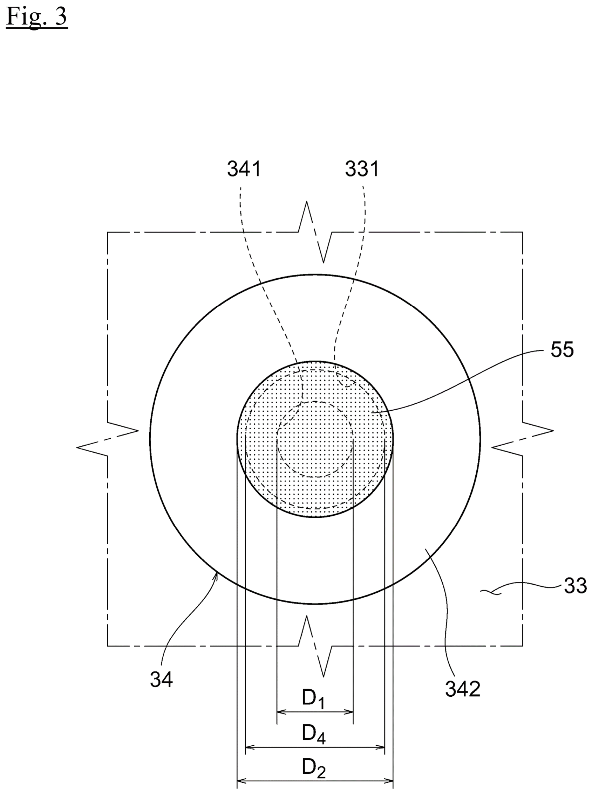

FIG. 1 is a cross-sectional view showing the device-embedded board 1 in the present embodiment. FIG. 2 is a cross-sectional view showing the re-wiring structure 30 of the electronic device 10 in the present embodiment and is an enlarged view of portion II in FIG. 1. FIG. 3 is a diagram showing the positional relationship between the conductive paste via 55 and the concave part 341 of the conductive layer 34 in the present embodiment and is a cross-sectional view taken along line III-III in FIG. 2. In order to facilitate understanding of the positional relationship between the conductive paste vias 55 and the concave part 341, the adhesive layer 53 is omitted in FIG. 3.

The device-embedded board 1 of the present embodiment is a multilayer wiring board with an electronic device embedded. Since the device-embedded board 1 can be miniaturized and thinned, the device-embedded board 1 can be used in medical equipment such as a wearable device and an implantable device. The application of the device-embedded board 1 is not limited to the above-described application, and the device-embedded board 1 may be used for purposes other than medical equipment.

As shown in FIG. 1, the device-embedded board 1 includes an electronic device 10, an inner board 40, and a plurality of (four in the present embodiment) outer boards 50 to 80. The electronic device 10 is mounted on the outer board 50. The outer board 50 is laid on one surface of the inner board 40 in a state in which the electronic device 10 is accommodated in an opening 411 formed in the inner board 40. The outer board 60 is laid on the other surface of the inner board 40 to cover the electronic device 10 in the opening 411. The outer boards 70 and 80 are laid on the outer boards 50 and 60 to be respectively located outside the outer boards 50 and 60.

The configuration of the device-embedded board 1 is not particularly limited to that described in the present embodiment. For example, the number and arrangement of electronic devices embedded in the device-embedded board 1 are not particularly limited to the above. The device-embedded board 1 may include a plurality of electronic devices. In this case, the inner board may have the openings the number of which corresponding to the number of electronic devices, or the device-embedded board 1 may include the inner boards the number of which corresponding to the number of electronic devices. As long as the device-embedded board 1 includes two outer boards laid on both sides of the inner board, the number of outer boards included in the device-embedded board 1 is not particularly limited to the above. Furthermore, other electronic devices may be mounted on the outer surface of the outermost outer board.

The electronic device 10 corresponds to an example of the "electronic device" in the aspect of the present invention, the inner board 40 corresponds to an example of the "inner board" in the aspect of the present invention, and the opening 411 corresponds to an example of the "first opening" in the aspect of the present invention. Furthermore, the outer board 50 corresponds to an example of the "first outer board" in the aspect of the present invention, and the outer board 60 corresponds to an example of the "second outer board" in the aspect of the present invention.

As shown in FIG. 2, the electronic device 10 includes a device main body 20 and a re-wiring structure 30. The electronic device 10 is not particularly limited as long as it is a device including the re-wiring structure 30. As a specific example of the electronic device 10, for example, an IC (integrated circuit device), a diode, an IPD (integrated passive device), a silicon capacitor, or the like can be exemplified.

The device main body 20 is a semiconductor substrate having electrode pads 21 and an insulating film 22 in one main surface 201. The main surface 201 corresponds to an example of the "first main surface" in the aspect of the present invention. The insulating film 22 is an inorganic insulating film made of, for example, silicon oxide or silicon nitride. The electrode pads 21 are exposed from openings 221 of the insulating film 22 and are electrically connected to a circuit (not shown) formed on the semiconductor substrate.

The re-wiring structure 30 is disposed on the main surface 201 of the device main body 20. The re-wiring structure 30 is a structure formed by alternately stacking insulating layers and wiring layers. The re-wiring structure 30 of the present embodiment includes an insulating layer 31, a wiring layer 32, an insulating layer 33, and a wiring layer 34, and has two combinations of an insulating layer and a wiring layer. The configuration of the re-wiring structure 30 is not particularly limited to this, and the re-wiring structure may have three or more combinations of the insulating layer and the wiring layer, or the re-wiring structure may have only one combination of the insulating layer and the wiring layer.

The insulating layer 31 is an organic insulating film made of, for example, polyimide, and is laid on the insulating film 22 of the device main body 20. The insulating layer 31 has an opening 311 at a position facing the electrode pad 21 of the device main body 20. The electrode pad 21 is exposed from the insulating layer 31 through the opening 311.

The wiring layer 32 is formed on the insulating layer 31. The wiring layer 32 is made of a conductive material such as copper and is a wiring pattern having a predetermined pattern shape. The wiring layer 32 is disposed on the insulating layer 31 to cover the opening 311 of the insulating layer 31 and is connected to the electrode pad 21 of the device main body 20 through the opening 311.

Similarly to the insulating layer 31 described above, the insulating layer 33 is an organic insulating film made of, for example, polyimide. The insulating layer 33 is laid on the insulating layer 31 to cover the wiring layer 32. The insulating layer 33 has an opening 331 at a position facing a conductive paste via 55 of the outer board 50 described later. A part of the wiring layer 32 is exposed from the insulating layer 33 through the opening 331 .

The wiring layer 34 is formed on the insulating layer 33. Similarly to the wiring layer 32 described above, the wiring layer 34 is made of an electrically conductive material such as copper and is a wiring pattern having a predetermined pattern shape. Although not particularly limited, in the present embodiment, the wiring layer 34 is a circular pad having an outer diameter larger than the inner diameter of the opening 331. The wiring layer 34 is disposed on the insulating layer 33 to cover the opening 331 of the insulating layer 33 and is connected to the wiring layer 32 exposed from the insulating layer 33 through the opening 331. That is, the wiring layer 34 has a concave part 341 which is a portion disposed within the opening 331 of the insulating layer 33, and a convex part 342 which is a portion disposed on the insulating layer 33.

As shown in FIG. 2 and FIG. 3, the diameter D₁ of the concave part 341 of the wiring layer 34 is smaller than the diameter D₂ of the conductive paste via 55 of the outer board 50 described later (D₁<D₂). In this case, if the diameter D₄ (refer to FIG. 3) of the opening 331 of the insulating layer 33 is made smaller than the diameter D₂ of the conductive paste via 55 (D₁<D₄), the diameter D₁ of the concave part 341 can be reliably made smaller than the diameter D₂ of the conductive paste via 55. In addition, the conductive paste via 55 is connected to both the concave part 341 and the convex part 342 of the wiring layer 34 of the electronic device 10, and the conductive paste via 55 is connected to the portion of the convex part 342 adjacent to the outer edge of the concave part 341 over the entire circumference.

Although the concave part 341 of the wiring layer 34 has a circular planar shape in the present embodiment, the planar shape of the concave part 341 is not limited to this. For example, the planar shape of the concave part 341 may be rectangular. The planar shape of the concave part 341 is set according to the shape of the opening 331 of the insulating layer 33. Further, although the convex part 342 of the wiring layer 34 also has a circular planar shape, the planar shape of the convex part 342 is not limited to this as long as it has a shape that encompasses the concave part 341 of the wiring layer 34. Similarly, the cross-sectional shape of the conductive paste via 55 is not limited to a circular shape as long as it has a shape that encompasses the concave part 341 of the wiring layer 34.

The insulating layer 33 corresponds to an example of the "first insulating layer" in the aspect of the present invention, the opening 331 corresponds to an example of the "second opening" in the aspect of the present invention, and the wiring layer 34 corresponds to an example of the "first wiring layer" in the aspect of the present invention. The insulating layer 31 corresponds to an example of the "second insulating layer" in the aspect of the present invention, the opening 311 corresponds to an example of the "third opening" in the aspect of the present invention, and the wiring layer 32 corresponds to an example of the "second wiring layer" in the aspect of the present invention.

As shown in FIG. 1, the inner board 40 is a double-sided wiring board including an insulating substrate 41, wiring layers 42 and 43, and vias 44. The configuration of the inner board 40 is not particularly limited to that described in the present embodiment as long as the inner board 40 has an opening 411. For example, the inner board 40 may be a single-sided wiring board.

The insulating substrate 41 is made of an electrically insulating material such as a resin material. As a specific example of the material of which the insulating substrate 41 is made, for example, polyimide, polyolefin, liquid crystal polymer (LCP), or the like can be exemplified. Although not particularly limited, the insulating substrate 41 has a thickness of, for example, about 25 µm. The insulating substrate 41 has an opening 411 that penetrates the insulating substrate 41 in the thickness direction thereof. The opening 411 has a size capable of accommodating the electronic device 10 described above.

Each of the wiring layers 42 and 43 is made of a conductive material such as a metal material. As a specific example of a material of which each of the wiring layers 42 and 43 is made, copper or the like can be exemplified. The wiring layers 42 and 43 are formed on both main surfaces of the insulating substrate 11 and have predetermined pattern shapes. The pattern shapes of the wiring layers 42 and 43 may be arbitrary shapes.

The via 44 is an interlayer conductive path that electrically connects the wiring layers 42 and 43 formed on both main surfaces of the insulating substrate 11. The via 44 is formed by filling the inside of a through hole 412 penetrating the insulating substrate 41 in the thickness direction thereof with copper by plating. The configuration of the via 44 is not particularly limited as long as it electrically connects the wiring layers 42 and 43. For example, the via 44 may be a via configured by forming a copper layer on the inner wall surface of the through hole 412.

The outer board 50 is a single-sided wiring board including an insulating substrate 51, a wiring layer 52, an adhesive layer 53, and conductive paste vias 54 and 55. The wiring layer 52 corresponds to an example of the "third wiring layer" in the aspect of the present invention, the adhesive layer 53 corresponds to an example of the "adhesive layer" in the aspect of the present invention, and the conductive paste via 55 corresponds to an example of the "conductive paste via" in the aspect of the present invention. The configuration of the outer board 50 is not particularly limited to that described in the present embodiment as long as the outer board 50 has the conductive paste via 55. For example, the inner board 40 may be a double-sided wiring board.

The insulating substrate 51 is made of an electrically insulating material such as a resin material. As a specific example of the material of which the insulating substrate 51 is made, for example, polyimide, polyolefin, liquid crystal polymer (LCP), or the like can be exemplified. Although not particularly limited, the insulating substrate 41 has a thickness of, for example, about 25 µm.

The wiring layer 52 is made of a conductive material such as a metal material. As a specific example of a material of which the wiring layer 52 are made, copper or the like can be exemplified. The wiring layer 52 is formed on one main surface 511 of the insulating substrate 51 and has a predetermined pattern shape. The main surface 511 corresponds to an example of the "second main surface" in the aspect of the present invention. The pattern shape of the wiring layer 52 may be an arbitrary shape.

The adhesive layer 53 is laid on the other main surface 512 of the insulating substrate 51. The main surface 512 corresponds to an example of the "third main surface" in the aspect of the present invention. The adhesive layer 53 is formed, for example, by curing an organic adhesive containing a volatile component, such as an epoxy-based adhesive or an acrylic-based adhesive.

Through holes 501 and 502 are formed in the insulating substrate 51 and the adhesive layer 53 and penetrate the insulating substrate 51 and the adhesive layer 53 in the thickness direction thereof. The through hole 501 is disposed to correspond to the wiring layer 43 of the inner board 40. On the other hand, the through hole 502 is disposed to correspond to the wiring layer 34 of the electronic device 10. The through hole 502 corresponds to an example of the "through hole" in the aspect of the present invention. Each of the through holes 501 and 502 is closed by the wiring layer 52 on the main surface 511 of the insulating substrate 51.

The conductive paste via 54 is an interlayer conductive path that electrically connects the wiring layer 52 and the wiring layer 43 of the inner board 40. On the other hand, the conductive paste via 55 is a conductive path that electrically connects the wiring layer 52 and the wiring layer 34 of the electronic device 10. The conductive paste vias 54 and 55 are formed by curing the conductive paste filled in the through holes 501 and 502. The conductive paste via 54 electrically connects the wiring layers 43 and 52 by contacting or combining the metal particles contained in the conductive paste via 54. Similarly, the conductive paste via 55 electrically connects the wiring layers 52 and 34 by contacting or combining the metal particles contained in the conductive paste via 55.

The conductive paste constituting the conductive paste vias 54 and 55 includes, for example, at least one kind of low electrical resistance metal particles selected from nickel, gold, silver, copper, aluminum, iron, and the like, and at least one kind of low melting point metal particles selected from tin, bismuth, indium, lead, and the like. The conductive paste is composed of a paste in which these metal particles are mixed with a binder component containing epoxy, acrylic, urethane, or the like as a main component.

The conductive paste configured in this manner has metal sintering type characteristics in which a curing temperature is approximately 150°C to 200°C and a melting point after curing is 260°C or higher. For example, the low melting point metal particles can be melted at 200°C or lower to form an alloy, and, in particular, it can form an intermetallic compound with copper, silver, or the like. Therefore, the connection between the conductive paste via 54 and the wiring layers 52 and 43 and the connection between the conductive paste via 55 and the wiring layers 52 and 34 are alloyed by the intermetallic compound at the time of the collective thermal compression bonding described later.

As the conductive paste, a paste obtained by mixing the low electrical resistance metal particles such as nickel with the binder component may be used. In this case, the conductive paste is electrically connected by contacting the metal particles. Alternatively, as the conductive paste, for example, a nano-paste in which a filler such as gold, silver, copper, or nickel having a nano-level particle size is mixed with the binder component may be used.

The outer board 60 has a similar configuration to the outer board 50 described above except that the outer board 60 does not have the conductive paste via 55. That is, the outer board 60 includes an insulating substrate 61, a wiring layer 62, an adhesive layer 63, and a conductive paste via 64. The conductive paste via 64 electrically connects the wiring layer 62 to the wiring layer 42 of the inner board 40.

Each of the outer boards 70 and 80 also has a similar configuration to the outer board 50 described above except that each of the outer boards 70 and 80 does not have the conductive paste via 55. That is, the outer board 70 includes an insulating substrate 71, a wiring layer 72, an adhesive layer 73, and a conductive paste via 74. The conductive paste via 74 electrically connects the wiring layer 72 to the wiring layer 52 of the outer board 50. The outer board 80 also includes an insulating substrate 81, a wiring layer 82, an adhesive layer 83, and a conductive paste via 84. The conductive paste via 84 electrically connects the wiring layer 82 to the wiring layer 62 of the outer board 60.

The device-embedded board 1 is formed by stacking the electronic device 10, the inner board 40, and the outer boards 50 to 80 described above in the following manner.

That is, the inner board 40 is laid on the outer board 50. The electronic device 10 is accommodated in the opening 411 of the inner board 40. The outer board 50 and the inner board 40 are bonded to each other via the adhesive layer 53. The wiring layer 43 of the inner board 40 and the wiring layer 52 of the outer board 50 are connected to each other via the conductive paste via 54. The wiring layer 34 of the electronic device 10 and the wiring layer 52 of the outer board 50 are connected to each other via the conductive paste via 55.

The outer board 70 is laid on the outer surface of the outer board 50. The outer boards 50 and 70 are bonded to each other via the adhesive layer 73. The wiring layers 52 and 72 of the outer boards 50 and 70 are connected to each other via the conductive paste via 74.

On the other hand, the outer board 60 is laid on the inner board 40 to cover the electronic device 10. The outer board 60 and the inner board 40 are bonded to each other via the adhesive layer 63. The wiring layer 42 of the inner board 40 and the wiring layer 62 of the outer board 60 are connected to each other via the conductive paste via 64.

The outer board 80 is laid on the outer surface of the outer board 60. The outer boards 60 and 80 are bonded to each other via the adhesive layer 83. The wiring layers 62 and 82 of the outer boards 60 and 80 are connected to each other via the conductive paste via 84.

As described above, in the present embodiment, the wiring layer 34 of the electronic device 10 includes the convex part 342 in addition to the concave part 341, and the conductive paste via 55 is connected to the convex part 342 and the concave part 341. Therefore, as will be described later, the conductive paste can be first brought into contact with the convex part 342 when the electronic device 10 is temporarily fixed to the outer board 50, and the interposition of the adhesive layer 53 between the conductive paste via 55 and the wiring layer 34 of the electronic device 10 can be suppressed. In addition, since the conductive paste and the wiring layer 34 contact each other at the convex part 342, the contact pressure of the conductive paste against the wiring layer 34 can be increased, and the conductive particles of the conductive paste via 55 can be sufficiently contacted with the wiring layer 34. Therefore, it is possible to improve the reliability of the electrical connection between the electronic device 10 and the outer board 50.

Furthermore, in the present embodiment, since the concave part 341 has an inner diameter D₁ that is smaller than the outer diameter D₂ of the conductive paste via 55 (D₁<D₂) and the conductive paste via 55 is connected to the portion of the convex part 342 adjacent to the outer edge of the concave part 341 over the entire circumference, it is possible to enhance the reliability of suppressing the interposition of the adhesive layer 53 between the conductive paste via 55 and the wiring layer 34 of the electronic device 10.

Further, in the present embodiment, since the convex part 342 of the wiring layer 34 is disposed on the insulating layer 33, the re-wiring structure 30 of the electronic device 10 has a step 35 (refer to FIG. 2) between the convex part 342 and the insulating layer 33. Since the adhesive layer 53 of the outer board 50 enters the step 35, it is possible to strengthen the adhesion between the electronic device 10 and the outer board 50.

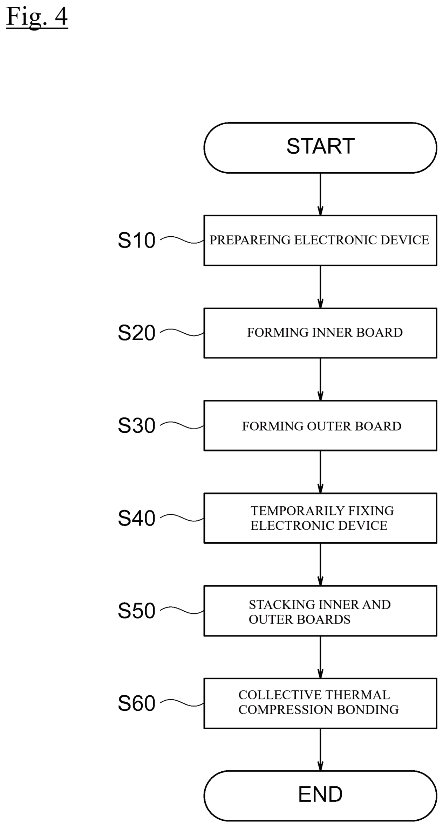

Hereinafter, a method of manufacturing the device embedded board 1 in the present embodiment will be described with reference to FIG. 4 to FIG. 9(d). As described below, the device embedded board 1 of the present embodiment is manufactured by individually forming the inner board 40 and the outer boards 50 to 80 and then stacking them to each other. FIG. 4 is a flowchart showing the method of manufacturing the device-embedded board 1 in the present embodiment.

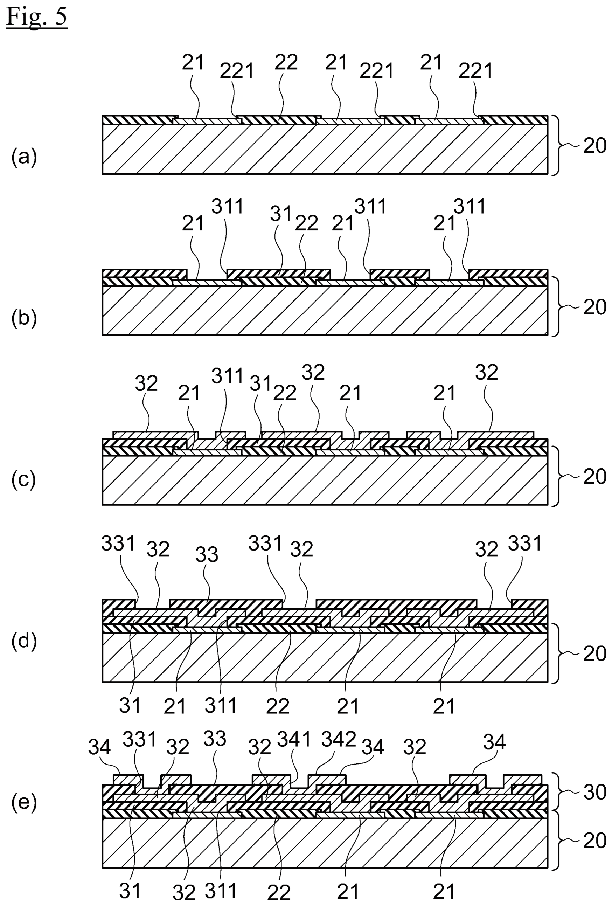

First, in step S10 of FIG. 4, the electronic device 10 is prepared. FIG. 5(a) to FIG. 5(e) are cross-sectional views showing the method of forming the re-wiring structure 30 of the electronic device 10 in the present embodiment and are diagrams showing details of step S10 in FIG. 4.

As shown in FIG. 5(a), in step S10, first, the device main body 20 including the electrode pad 21 and the insulating film 22 is prepared. A circuit (not shown) is formed in the device main body 20 by selective diffusion technology or the like, and the electrode pad 21 is electrically connected to this circuit.

Next, a chemical solution is applied over the entire surface of the device main body 20 to form a thin film. Then, as shown in FIG. 5(b), openings 311 are formed in this thin film by photolithography technology, and then the insulating layer 31 is formed by firing the thin film.

As a specific example of the chemical solution described above, for example, photosensitive resin material such as photosensitive polyimide precursors, benzocyclobutene (BCB), and polybenzoxazole (PBO), or the like can be exemplified. As a specific example of the method of applying the chemical solution to the device main body 20, for example, spin coating, curtain coating, screen printing, spray coating, or the like can be exemplified. Instead of the above-mentioned liquid photosensitive resin, a photosensitive resin film may be laid on the device main body 20.

Next, as shown in FIG. 5(c), the wiring layer 32 is formed on the insulating layer 31 by a semi-additive process. The wiring layer 32 is formed within the opening 311 as well as on the upper surface of the insulating layer 31, and the wiring layer 32 is connected to the electrode pad 21 of the device main body 20 within the opening 311.

Next, a chemical solution is applied over the entire surface of the insulating layer 31, and a thin film is formed on the insulating layer 31 to cover the wiring layer 32. Then, as shown in FIG. 5(d), the opening 331 is formed in this thin film by photolithography technology, and then the insulating layer 33 is formed by firing the thin film. A part of the wiring layer 32 is exposed from the opening 331 of the insulating layer 33. As a specific example of the chemical solution and applying method, the same as those for the insulating layer 31 described above can be exemplified.

Next, as shown in FIG. 5(e), the wiring layer 34 is formed on the insulating layer 33 by a semi-additive process. The wiring layer 34 is formed within the opening 331 as well as on the upper surface of the insulating layer 33, and the wiring layer 34 is connected to the wiring layer 32 within the opening 331. That is, the concave part 341 of the wiring layer 34 is disposed within the opening 331 of the insulating layer 33, and the convex part 342 of the wiring layer 34 is disposed on the insulating layer 33.

Although the re-wiring structure 30 is individually formed for one device main body 20 in the examples shown in FIG. 5(a) to FIG. 5(e), the method of forming the re-wiring structure 30 is not particularly limited to this. For example, although not particularly shown, the re-wiring structures 30 may be collectively formed for a plurality of device main bodies 20 in a state in which the plurality of device main bodies 20 are formed on a single semiconductor wafer (i.e., the state before the semiconductor wafer is diced), and then the individual electronic devices 10 may be singulated by dicing the semiconductor wafer.

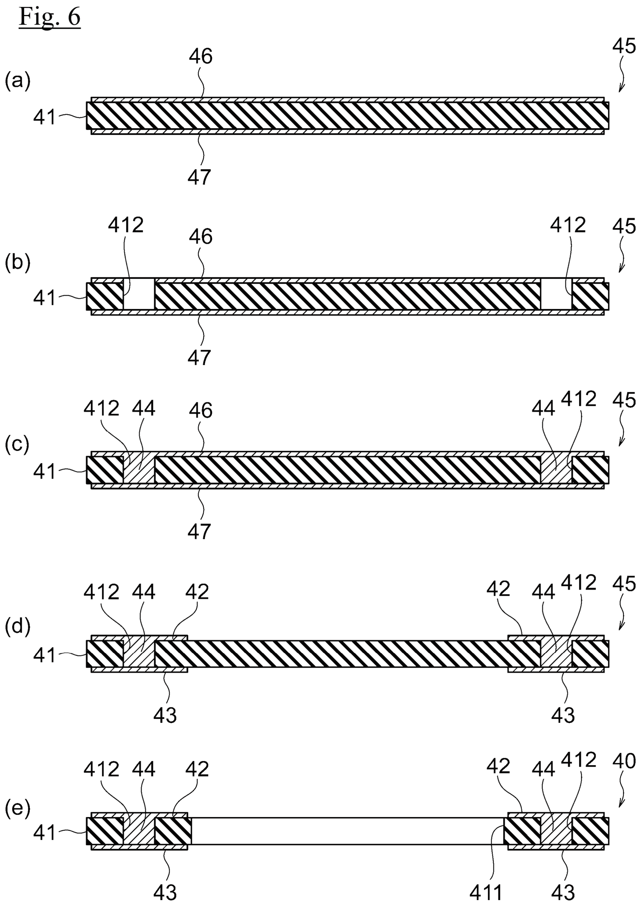

Next, in step S20 of FIG. 4, the inner board 40 is formed. FIG. 6 (a) to FIG. 6 (e) are cross-sectional views showing the method of forming the inner board 40 in the present embodiment and are diagrams showing details of step S20 in FIG. 4.

In step S20, first, a CCL (Copper Clad Laminate) 45 is prepared as shown in FIG. 6(a). The CCL 45 is a double-sided CCL including the insulating substrate 41 and conductor layers 46 and 47 laid on both sides of the insulating substrate 41. Although not particularly limited, as a specific example of the double-sided CCL 45, for example, one produced by laying copper foils each having a thickness of about 12µm on both surfaces of a polyimide film having a thickness of about 25µm, can be exemplified. One produced by a so-called casting method in which a polyimide varnish is applied to a copper foil and the varnish is cured may be used as the CCL. Alternatively, one produced by forming a seed layer on a polyimide film and growing copper by plating may be used as the CCL.

Next, as shown in FIG. 6(b), the through hole 412 that penetrates the insulating substrate 41 is formed. Specifically, first, the conductor layer 46 is etched to remove a portion of the conductor layer 46, and then the removed portion is irradiated with laser light using a UV-YAG laser device to form the through hole 412 in the insulating substrate 41. The etching process of the conductor layer 46 before the laser light irradiation may be omitted. Instead of the UV-YAG laser device, the through-hole 412 may be formed in the insulating substrate 41 by a carbon dioxide laser (CO₂ laser), an excimer laser, or the like. Alternatively, the through hole 412 may be formed in the insulating substrate 41 by drilling, chemical etching, or the like.

The through-hole 412 may be subjected to a plasma desmear process. Although the desmear process may be performed using a mixed gas of CF₄ and O₂ (tetrafluoromethane + oxygen), an inert gas such as Ar (argon) may also be used. As the desmear process, a wet desmear process using a chemical solution may be used instead of a so-called dry process.

Next, as shown in FIG. 6(c), the CCL45 is subjected to a panel-plating process to grow copper plating in the through holes 412, therefore the via 44 is formed in the through holes 412.

Next, as shown in FIG. 6(d), an etching resist is formed on the conductor layers 46 and 47 by photolithography or the like, and then etching is performed to form the wiring layers 42 and 43 into patterns. An etchant containing ferric chloride, cupric chloride, or the like as a main component may be used in the above-described etching. The wiring layers 42 and 43 may be formed on the insulating substrate 41 using a semi-additive process without using the CCL 45.

Next, as shown in FIG. 6(e), the insulating substrate 41 is irradiated with a laser beam using a UV-YAG laser device to form the opening 411 in the insulating substrate 41. The opening 411 may be formed by punching using a die. In this manner, the inner board 40 is formed.

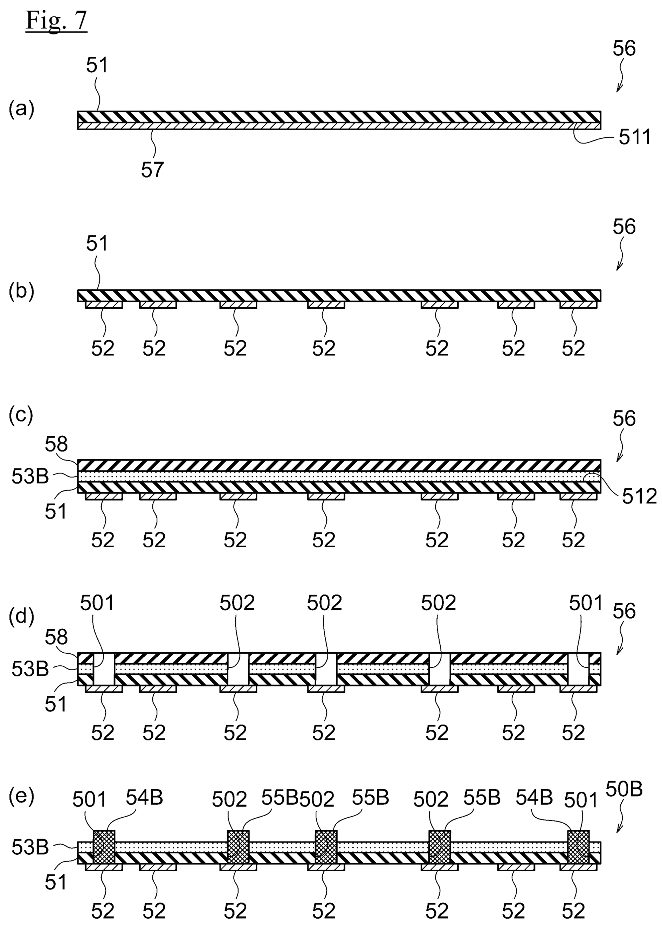

Next, in step S30 of FIG. 4, the outer boards 50B to 80B are formed. FIG. 7 (a) to FIG. 7 (e) are cross-sectional views showing the method of forming the outer board 50B in the present embodiment and are diagrams showing details of step S30 in FIG. 4.

Here, the outer boards 50 to 80 described above include the cured adhesive layers 53 to 83 and the cured conductive paste vias 54 to 84 and 55, whereas the outer boards 50B to 80B described below are different in that they include the pre-cured adhesive 53B to 83B and the pre-cured conductive paste 54B to 84B and 55B. The adhesives 53B to 83B are cured to form the adhesive layers 53 to 83, and the conductive pastes 54B to 84B and 55B are cured to form the conductive paste vias 54 to 84 and 55. Therefore, the outer board 50B also corresponds to an example of the "first outer board" in the aspect of the present invention, and the outer board 60B also corresponds to an example of the "second outer board" in the aspect of the present invention. As described above, since the outer boards 50 to 80 have the same configuration except for the presence or absence of the conductive paste vias 55, the methods of forming the outer boards 50B to 80B are also the same except for the presence or absence of the step of forming the conductive paste vias 55. Therefore, only a method of forming the outer board 50B will be described below, and a detailed description of a method of forming the outer boards 60B to 80B will be omitted.

In step S30, first, a CCL 56 is prepared as shown in FIG. 7(a). The CCL 56 is a single-sided CCL including the insulating substrate 51 and a conductor layer 57 laid on one main surface 511 of the insulating substrate 51. Although not particularly limited, as a specific example of the single-sided CCL 56, for example, one produced by laying a copper foil having a thickness of about 12µm on one surface of a polyimide film having a thickness of about 25µm, can be exemplified.

Next, as shown in FIG. 7(b), an etching resist is formed on the conductor layer 57 by photolithography or the like, and then etching is performed to form the wiring layer 52 into patterns. The wiring layer 52 may be formed on the insulating substrate 51 using a semi-additive process without using the CCL 56.

Next, as shown in FIG. 7(c), the adhesive 53B and the resin film 58 are sequentially stacked on the other main surface 512 of the insulating substrate 51 and bonded by thermal compression bonding. Although not particularly limited, as a specific example of the adhesive 53B, for example, an epoxy-based thermosetting film having a thickness of about 25 µm can be exemplified. As a specific example of the resin film 58, for example, a polyimide resin film having a thickness of 25µm can be exemplified. The adhesive 53B and the resinous film 58 are bonded to the insulating substrate 51 by heating and pressing the adhesive 53B using a vacuum laminator at a temperature lower than or equal to the curing temperature of the adhesive 53B in a reduced pressure atmosphere. As the adhesive 53B, a varnish-like adhesive may be used instead of the film-like adhesive, and in this case, the adhesive 53B is applied to the other main surface 512 of the insulating substrate 51.

Next, as shown in FIG. 7(d), the through holes 501and 502 penetrating the resin film 58, the adhesive 53B, and the insulating substrate 51 are formed. Specifically, the through holes 501 and 502 are formed by irradiating the resin film 58 with laser light from the upper side in the figure. Instead of laser processing, the through holes 501 and 502 may be formed by drilling, chemical etching, or the like. The through holes 501 and 502 may also be subjected to a desmear process.

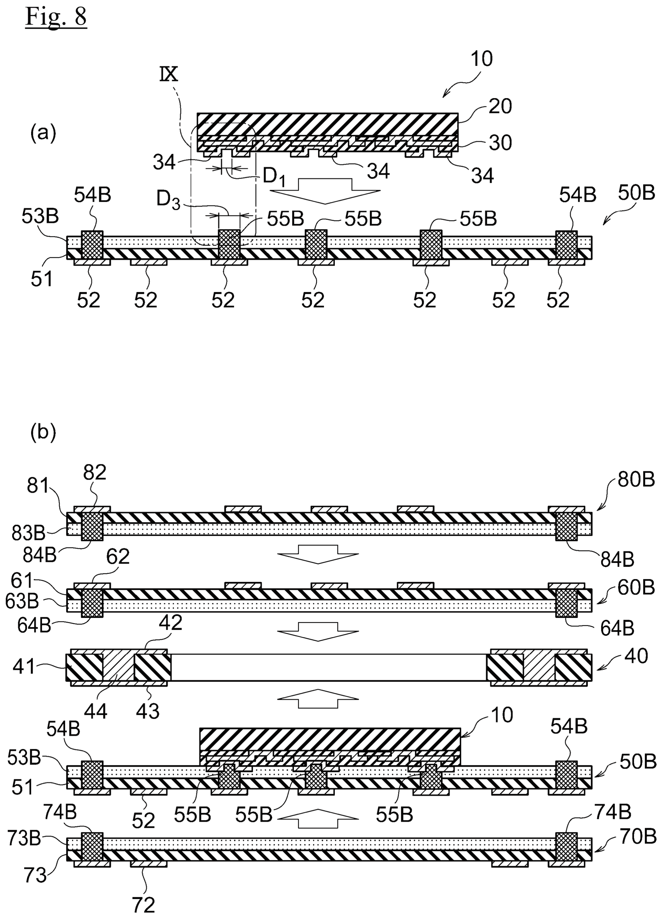

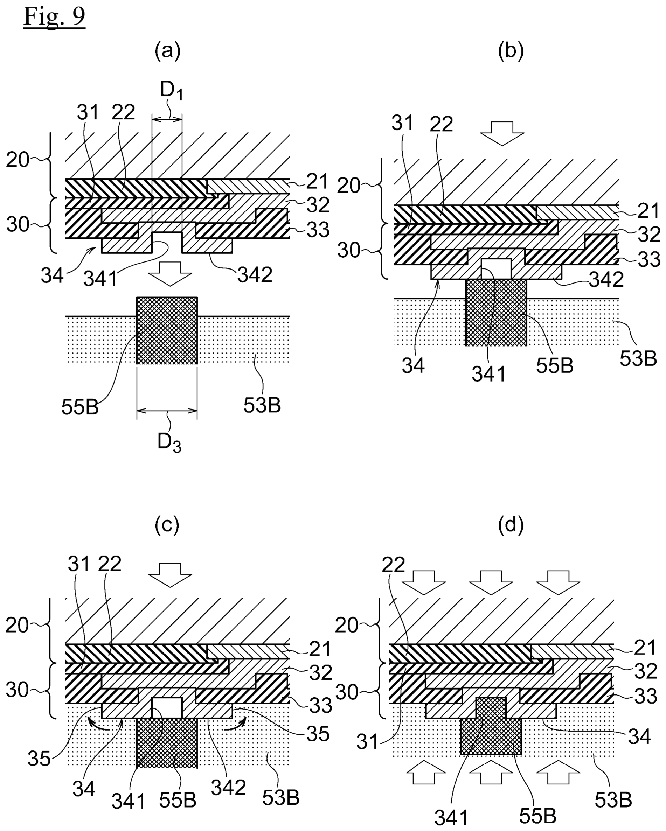

Next, as shown in FIG. 7(e), the conductive pastes 54B and 55B are filled in the through holes 501 and 502, and then the resin film 58 is peeled off from the adhesive 53B. As a result, the tip portions of the conductive pastes 54B and 55B protrude from the surface of the adhesive 53B by an amount corresponding to the thickness of the resin film 58. As shown in FIG. 8(a) and FIG. 9(a) described later, the conductive paste 55B has an outer diameter D₃ larger than the inner diameter D₁ of the convex part 341 of the wiring layer 34 of the electronic device 10 (D₃>D₁). As a specific method of filling the through holes 501 and 502 with the conductive pastes 54B and 55B, for example, a printing method such as screen printing, a spin coating method, a spray coating method, a dispensing method, and a laminating method, or the like can be exemplified.

The order of steps S10 to S30 of steps shown in FIG. 4 is not particularly limited to the above. For example, steps S10 to S30 may be performed in parallel. Further, the order of steps S20 and S30 described above and step S40 described later is not particularly limited to the order shown in FIG. 4. For example, steps S20 to S40 may be performed in parallel. Steps S10 to S30 in FIG. 4 correspond to an example of the "first step" in the aspect of the present invention.

Next, in step S40 of FIG. 4, the electronic device 10 is temporarily fixed to outer board 50B as shown in FIG. 8(a). FIG. 8(a) is a cross-sectional view showing the method of forming the device-embedded board 1 in the present embodiment and is a diagram showing step S40 in FIG. 4. FIG. 9(a) to FIG. 9(c) are enlarged views corresponding to portion IX in FIG. 8(a). Step S40 in FIG. 4 corresponds to an example of the "second step" in the aspect of the present invention.

Specifically, first, as shown in FIG. 9(a), the electronic device 10 is positioned with respect to the outer board 50B by using an electronic device mounter (not shown) so that the concave part 341 of the wiring layer 34 is located above the conductive paste 55B. At this time, the electronic device 10 is positioned with respect to the outer board 50B so that the conductive paste 55B overlaps with both the convex part 342 and the concave part 341 of the wiring layer 34 when viewed along the pressing direction for pressing the electronic device 10 and the outer board 50B (when viewed along the normal direction to the main surface of the outer board 50B (refer to FIG. 3)). Specifically, since the inner diameter D₁ of the concave part 341 is smaller than the outer diameter D₃ of the conductive paste 55B (D₁<D₃) as described above, the electronic device 10 is positioned with respect to the outer board 50 so that the conductive paste 55B overlaps with a portion of the convex part 342 adjacent to the outer edge of the concave part 341 over the entire circumference.

Once the positioning of the electronic device 10 with respect to the outer board 50 is completed, the electronic device 10 is lowered toward the outer board 50 by the electronic device mounter (not shown). In the present embodiment, as the electronic device 10 is lowered, the convex part 342 of the wiring layer 34 first comes into contact with the conductive paste 55B (refer to FIG. 9(b)), and thereafter, the adhesive 53B comes into contact with the convex part 342 of the wiring layer 34 and the insulating layer 33 (see FIG. 9(c)). At this time, the conductive paste 55B contacts a portion of the convex part 342 that is adjacent to the outer edge of the recess 341 over the entire circumference. Then, by heating and pressing the electronic device 10 and the outer board 50B in this condition, the adhesive 53B is interposed between the insulating layer 33 of the electronic device 10 and the insulating substrate 51 of the outer board 50B, and the electronic device 10 is temporarily fixed to the outer board 50B. The electronic device 10 is pressed against the adhesive 53B softened by this heating, and the wiring layer 34 is embedded in the adhesive 53B. Therefore, the adhesion between the electronic device 10 and the outer board 50 can be strengthened. In this condition, the conductive paste 55B may be contacted with the concave part 341 in addition to the convex part 342.

The heating temperature at this time is a temperature equal to or lower than the curing temperature of the adhesive 53B, and the adhesive 53B is softened by this heating. The heating temperature may be a temperature equal to or lower than the curing temperature of the conductive paste 55B. The pressing pressure at this time is approximately 0.5N to 50N. By pressing the electronic device 10 and the outer substrate 50B with such pressure, the conductive particles contained in the conductive paste 55B can be brought into sufficient contact with wiring layer 34 of the electronic device 10. As long as the heating in step S40 can soften the adhesive 53B, in the heating in step S40, both the electronic device 10 and the outer board 50B may be heated, only the electronic device 10 may be heated, or only the outer board 50B may be heated.

Further, in the present embodiment, since the adhesive 53B comes into contact with the convex part 342 and the insulating layer 33 after contacting between the convex part 342 and the conductive paste 55B, it is possible to suppress the inflow of the adhesive 53B between the convex part 342 and the conductive paste 55B. At this time, since the concave part 341 has the inner diameter D₁ smaller than the outer diameter D₃ of the conductive paste 55B (D₁<D₃) and the conductive paste 55B is in contact with the portion of the convex part 342 adjacent to the outer edge of the concave part 341 over the entire circumference, it is possible to enhance the reliability of suppressing the inflow of the adhesive 53B.

Further, in the present embodiment, since the conductive paste 55B and the wiring layer 34 come into contact with each other at the convex part 342, the contact pressure of the conductive paste 55B against the wiring layer 34 can be increased, and the conductive particles of the conductive paste 55B can be brought into sufficient contact with the wiring layer 34.

Furthermore, in the present embodiment, since the adhesive 53B enters the step 35 (refer to FIG. 9(c)) of the re-wiring structure 30 of the electronic device 10, it is possible to strengthen the adhesion between the electronic device 10 and the outer board 50.

Next, in step S50 of FIG. 4, the outer board 50 to which the electronic device 10 is temporarily fixed, the other outer boards 60 to 80, and the inner board 40 are stacked while being positioned with respect to each other as shown in FIG. 8(b). FIG. 8(b) is a cross-sectional view showing the method of forming the device-embedded board 1 in the present embodiment and is a diagram showing step S50 in FIG. 4. Step S50 of FIG. 4 corresponds to an example of the "third step" in the aspect of the present invention.

Specifically, the inner board 40 is sandwiched between the outer boards 50B and 60B while inserting the electronic device 10 temporarily fixed to the outer board 50B into the opening 411 of the inner board 40, and then they are sandwiched between the outer boards 70B and 80B to stack the inner board 40 and the outer boards 50B to 80B.

At this time, the outer board 50B is laid on the lower surface of the inner board 40 so that the adhesive 53B contacts the insulating substrate 41 and the conductive paste 54B contacts the wiring layers 43. Similarly, the outer board 60B is laid on the upper surface of the inner board 40 so that the adhesive 63B contacts the insulating substrate 41 and the conductive paste 64B contacts the wiring layers 42.

In addition, the outer board 70B is laid on the lower surface of the outer board 50B so that the adhesive 73B contacts the insulating substrate 51 and the conductive paste 74B contacts the wiring layers 52. Similarly, the outer board 80B is laid on the upper surface of the outer board 60B so that the adhesive 83B contacts the insulating substrate 61 and the conductive paste 84B contacts the wiring layers 62.

Next, in the step S60 of FIG. 4, the inner board 40 and the outer boards 50B to 80B are collectively thermal compression bonded to each other to integrate them by applying heat and pressure in a reduced-pressure atmosphere of 1kPa or less by using a vacuum press machine. As a result, the device embedded board 1 including the electronic device 10, the inner board 40, and the outer boards 50 to 80 as shown in FIG. 1 is completed. Step S60 of FIG. 4 corresponds to an example of the "fourth step" in the aspect of the present invention.

At this time, the adhesives 53B and 63B flows by heating to fill the gap between the electronic device 10 and the inner surface of the opening 411 of the inner board 40, the adhesives 53B to 83B flows by heating to fill the gap between the insulating substrates 51 to 81, and thereafter, the adhesives 53B to 83B are cured to form the adhesive layers 53 to 83. In parallel with this, the conductive pastes 54B to 84B and 55B are cured to form the conductive paste vias 54 to 84 and 55.

In particular, as shown in FIG. 9(d), since the conductive paste 55B is further pressed in a state in which the conductive paste 55B and the wiring layer 34 are in close contact with each other at the convex part 342, the conductive particles of the conductive paste 55B can be brought into sufficient contact with the wiring layer 34, and it is possible to ensure the stable electrical connection between the conductive paste via 55 and the wiring layer 34. The conductive paste via 55 in contact with both the concave part 341 and the convex part 342 of the wiring layer 34 is formed by this pressing. FIG. 9(d) is a diagram showing details of step S60 in FIG. 4 and is an enlarged view corresponding to portion IX in FIG. 8(a).

As described above, in the present embodiment, the electronic device 10 and the outer board 50B are pressed in a state in which the conductive paste 55B is in contact with the wiring layer 34 of the electronic device 10 when the electronic device 10 and the outer board 50B are temporarily fixed to each other. Therefore, the manufacturing process can proceed to step S60 (the collective thermal compression bonding process) in a state in which the conductive particles of the conductive paste 55B are in sufficient contact with the conductor layer 34 of the electronic device 10, and the conductive paste 55B can be cured. Accordingly, it is possible to improve the reliability of the electric connection between the electronic device 10 and the outer board 50.

Further, in the present embodiment, the wiring layer 34 of the electronic device 10 includes the convex part 342 in addition to the concave part 341, and when the electronic device 10 is temporarily fixed to the outer board 50B, the electronic device 10 and the outer board 50B are pressed in a state in which the conductive paste 55 overlaps with the convex part 342 and the concave part 341 when viewed along the pressing direction. Therefore, the conductive paste 55B and the convex part 342 can be brought into contact with each other first, and it is possible to suppress the inflow of the adhesive 53B between the convex part 342 and the conductive paste 55B. Further, since the conductive paste 55B and the wiring layer 34 are in contact with each other at the convex part 342 when the electronic device 10 is temporarily fixed to the outer board 50B, the contact pressure of the conductive paste 55B with respect to the wiring layer 34 can be increased, and the conductive particles of the conductive paste 55B can be sufficiently brought into contact with the wiring layer 34. Therefore, it is possible to improve the reliability of the electrical connection between the electronic device 10 and the outer board 50.

It should be noted that the embodiment described above are described to facilitate understanding of the present disclosure and are not described to limit the present disclosure. It is therefore intended that the elements disclosed in the above embodiment include all design modifications and equivalents to fall within the technical scope of the present disclosure.

### [EXPLANATIONS OF LETTERS OR NUMERALS]

1 ... Device-embedded board
10 ... Electronic device
20 ... Device main body
201 ... Main surface
21 ... Electrode pad
22 ... Insulating film
221 ... Opening
30 ... Re-wiring structure
31 ... Insulating layer
311 ... Opening
32 ... Wiring layer
33 ... Insulating layer
331 ... Opening
34 ... Wiring layer
341 ... Concave part
342 ... Convex part
35 ... Step
40 ... Inner board
41 ... Insulating substrate
411 ... Opening
412 ... Through hole
42 ... Wiring layer
43 ... Wiring layer
44 ... Via
45 ... CCL
46 and 47 ... Conductive layer
50 and 50B ... Outer board
501 and 502 ... Through hole
51 ... Insulating substrate
511 and 512 ... Main surface
52 ... Wiring layer
53 ... Adhesive layer
53B ... Adhesive
54 and 55 ... Conductive paste via
54B and 55B ... Conductive paste
56 ... CCL
57 ... Conductive layer
58 ... Resin film
60 and 60B ... Outer board
61 ... Insulating substrate
62 ... Wiring layer
63 ... Adhesive layer
63B ... Adhesive
64 ... Conductive paste via
64B ... Conductive paste
70 and 70B ... Outer board
71 ... Insulating substrate
72 ... Wiring layer
73 ... Adhesive layer
73B ... Adhesive
74 ... Conductive paste via
74B ... Conductive paste
80 and 80B ... Outer board
81 ... Insulating substrate
82 ... Wiring layer
83 ... Adhesive layer
83B ... Adhesive
84 ... Conductive paste via
84B ... Conductive paste

## Claims

1. A method of manufacturing a device-embedded board comprising:
a first step of preparing an electronic device, an inner board having a first opening capable of accommodating the electronic device, a first outer board having a through hole filled with a conductive paste, and a second outer board;
a second step of temporarily fixing the electronic device to the first outer board;
a third step of stacking the first and second outer boards and the inner board with each other so that the electronic device is inserted into the first opening and the inner board is sandwiched between the first and second outer boards; and
a fourth step of fixing the first and second outer boards and the inner board to each other by heating and pressing the first and second outer boards and the inner board; wherein
the electronic device comprises:
a device main body having a first main surface in which an electrode pad is disposed;
a first insulating layer having a second opening and disposed on the first main surface side with respect to the device main body; and
a first wiring layer disposed on the first insulating layer to cover the second opening and electrically connected to the electrode pad,
the second step includes pressing the electronic device against the first outer board in a state in which the conductive paste is in contact with the first wiring layer.

2. The method of manufacturing the device-embedded board according to claim 1, wherein
the first wiring layer comprises:
a concave part disposed in the second opening; and
a convex part disposed on the first insulating layer, and
the second step includes pressing the electronic device against the first outer board in a state in which the conductive paste overlaps the convex part and the concave part when viewed along a pressing direction.

3. The method of manufacturing the device-embedded board according to claim 1 or 2, wherein
the first wiring layer comprises:
a concave part disposed in the second opening; and
a convex part disposed on the first insulating layer,
the concave part has an inner diameter smaller than an outer diameter of the conductive paste, and
the second step includes bringing the conductive paste into contact with a portion of the convex part adjacent to an outer edge of the concave part over an entire circumference.

4. The method of manufacturing the device-embedded board according to claim 2 or 3, wherein
the electronic device comprises:
a second insulating layer having a third opening and interposed between the device main body and the first insulating layer; and
a second wiring layer disposed on the second insulating layer to cover the third opening and electrically connected to the electrode pad,
the first insulating layer is laid on the second insulating layer so that the first insulating layer covers the second wiring layer and a part of the second wiring layer faces the second opening, and
the first wiring layer is connected to the second wiring layer via the second opening.

5. The method of manufacturing the device-embedded board according to claim 4, wherein
the second insulating layer is laid on the device main body so that the third opening faces the electrode pad.

6. The method of manufacturing the device-embedded board according to any one of claims 1 to 5, wherein
the first outer board comprises:
a substrate having an electrical insulation;
a third wiring layer disposed on a second main surface of the substrate; and
an adhesive disposed on a third main surface of the substrate,
the through hole penetrates the substrate and the adhesive and is closed by the third wiring layer,
the conductive paste is in contact with the third wiring layer, and
the second step includes pressing the electronic device against the first outer board while heating the adhesive in a state in which the conductive paste is in contact with the first wiring layer.

7. A device-embedded board comprising:
an electronic device;
a first outer board on which the electronic device is mounted,
an inner board having a first opening accommodating the electronic device and laid on the first outer board; and
a second outer board laid on the inner board to cover the electronic device,
the electronic device comprises:
a device main body having a first main surface in which an electrode pad is disposed;
a first insulating layer having a second opening and disposed on the first main surface side with respect to the device main body; and
a first wiring layer disposed on the first insulating layer to cover the second opening and electrically connected to the electrode pad,
the first wiring layer comprises:
a concave part disposed in the second opening; and
a convex part disposed on the first insulating layer,
the first outer board comprises a conductive paste via connected to the first wiring layer, and
the conductive paste via is connected to the convex part and the concave part.

8. The device-embedded board according to claim 7, wherein
the concave part has an inner diameter smaller than an outer diameter of the conductive paste via, and
the conductive paste via is connected to a portion of the convex part adjacent to an outer edge of the concave part over an entire circumference.

9. The device-embedded board according to claim 7 or 8, wherein
the electronic device comprises:
a second insulating layer having a third opening and interposed between the device main body and the first insulating layer; and
a second wiring layer disposed on the second insulating layer to cover the third opening and electrically connected to the electrode pad,
the first insulating layer is laid on the second insulating layer so that the first insulating layer covers the second wiring layer and a part of the second wiring layer faces the second opening, and
the first wiring layer is connected to the second wiring layer via the second opening.

10. The device-embedded board according to claim 9, wherein
the second insulating layer is laid on the device main body so that the third opening faces the electrode pad.

11. The device-embedded board according to any one of claims 7 to 10, wherein
the first outer board comprises:
an insulating substrate having an electrical insulation;
a third wiring layer disposed on a second main surface of the insulating substrate; and
an adhesive disposed on a third main surface of the insulating substrate,
the device-embedded board has a through hole that penetrates the insulating substrate and the adhesive and that is closed by the third wiring layer, and
the conductive paste via is disposed in the through hole and is connected to the third wiring layer.
